# EUROPEAN PATENT APPLICATION

(11) **EP 2 103 566 A2**
(43) Date of publication of application: **23.09.2009**
(21) Application number: 08103019.9
(22) Date of filing: 27.03.2008
(51) Int. Cl.: B81C 1/00

(54) **Micro-Hole substrates and methods of manufacturing the same**

(30) Priority: 17.03.2008 US 50016
(71) Applicant: Chen, Shi-Chiun, Guishan Shiang, Taoyuan (TW)
(72) Inventor: Chen, Shi-Chiun, Guishan Shiang, Taoyuan (TW)
(74) Representative: 2K Patentanwälte Blasberg Kewitz & Reichel

(57) **Abstract**

A method of fabricating a substrate with micro holes, the method comprising providing a roll of flexible film having a first surface and a second surface, the first surface and the second surface being separated from one another by a thickness of the roll of flexible film, identifying a depth of the micro holes to be formed, and punching the first surface of the roll of flexible film to form a plurality of micro holes with a depth into the first surface.

## Description

### BACKGROUND OF THE INVENTION

The present invention generally relates to micro fabrication and, more particularly, to substrates with micro holes and methods of manufacturing the same.

Display devices are commonly used in various electronic products such as cell phones, digital cameras, notebooks and personal digital assistant (PDA). Display devices may generally be formed on rigid substrates such as glasses and wafers, or flexible substrates such as polymers. With the increasing interest in compact, light-weight and low-profile electronic products, many products are manufactured with miniature feature sizes. For example, the progress in semiconductor manufacturing technologies satisfies the demands for down-sized electronic products and display devices. With this trend, the demand for flexible substrates for electrical applications has dramatically increased in the recent years. Because of their flexible behavior, the use of the flexible substrates may significantly lower the overall substrate thickness and weight. Moreover, the flexible substrates may increase the module compactness and can be applied to a curved surface or even a dynamic surface.

Micro-fabrication technology may be employed to manufacture flexible substrates for electrical applications. Micro-fabrication may refer to a fabrication process capable of forming a film or substrate with micro meshes or micro holes having a diameter ranging from approximately 100 to 500 micrometers (µm). Micro-hole substrates or micro-hole films may be applied to display devices to support luminance required for the display devices.

### BRIEF SUMMARY OF THE INVENTION

One example consistent with the invention may provide a method of fabricating a substrate with micro holes, the method comprising providing a roll of flexible film having a first surface and a second surface, the first surface and the second surface being separated from one another by a thickness of the roll of flexible film, identifying a depth of the micro holes to be formed, and punching the first surface of the roll of flexible film to form a plurality of micro holes with a depth into the first surface.

Another example consistent with the invention may provide method of fabricating a substrate with micro holes, the method comprising providing a roll of flexible film having a first surface and a second surface, punching the first surface of at least a section of the roll of flexible film to form a plurality of micro holes with a depth into the first surface of the section of the roll of flexible film, filling electroluminescent material into each of the micro holes, and sealing a top portion of each of the micro holes.

Still another example consistent with the present invention may provide a substrate for a display device, the substrate comprising a flexible film having a first surface and a second surface, a plurality of holes of a depth formed into the first surface of the flexible film, each of the holes having a diameter and being separated from an immediately adjacent hole by a distance, and a plurality of protrusions protruded from the second surface of the flexible film, each of the protrusions corresponding to one of the holes.

Other objects, advantages and novel features of the present invention will be drawn from the following detailed examples of he present invention with attached drawings, in which:

### BRIEF DESCRIPTION OF THE SEVERAL VIEWS OF THE DRAWINGS

The foregoing summary as well as the following detailed description of the preferred examples of the present invention will be better understood when read in conjunction with the appended drawings. For the purposes of illustrating the invention, there are shown in the drawings examples which are presently preferred. It is understood, however, that the invention is not limited to the precise arrangements and instrumentalities shown. In the drawings:

FIG. 1 is a schematic diagram illustrating an array of micro holes in accordance with an example of the present invention;

FIGS. 2A and 2B are schematic diagrams each illustrating an array of micro holes in accordance with another example of the present invention;

FIG. 3 is a schematic diagram illustrating an array of micro holes in accordance with yet another example of the present invention;

FIG. 4 is a schematic diagram illustrating an array of micro holes in accordance with still another example of the present invention;

FIGS. 5A and 5B are schematic diagrams illustrating a process of forming micro holes in accordance with an example of the present invention;

FIG. 6 is a schematic diagram illustrating a thin film display device in accordance with an example of the present invention; and

Fig. 7 is a flow diagram illustrating a method of manufacturing a substrate with micro holes in accordance with an example of the present invention.

### DETAILED DESCRIPTION OF THE INVENTION

Reference will now be made in detail to the present examples of the invention illustrated in the accompanying drawings. Wherever possible, the same reference numbers will be used throughout the drawings to refer to the same or like portions.

The present invention utilizes a micro-fabrication technology to form substrates with micro holes or ultra-micro holes. A general micro hole may refer to one having a diameter ranging from approximately 100 micrometers (µm) to 500 µm, while a general ultra-micro hole may refer to one having a diameter smaller than 100 µm. Throughout the specification, however, a micro hole may include one of the general micro hole and the general ultra-micro hole.

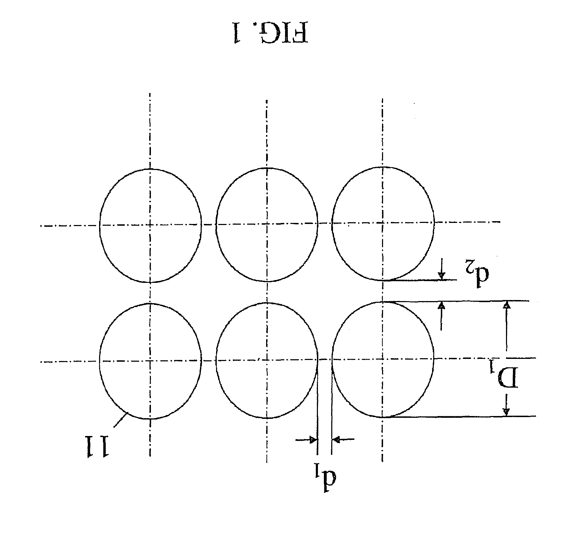

FIG. 1 is a schematic diagram illustrating an array of micro holes 11 in accordance with an example of the present invention. Referring to FIG. 1, the array of micro holes 11 may be arranged in a number of rows and columns. For simplicity, only two rows and three columns of the array are illustrated. In the present example, the number of rows and the number of columns may be orthogonal to one another. Furthermore, each of the micro holes 11 may have a circular shape of a diameter D₁. The micro holes 11 in one of the rows may be separated from each other edge to edge by a first distance d₁, and the micro holes 11 in one of the columns may be separated from each other edge to edge by a second distance d₂. In one example, the diameter D₁ of each of the micro holes 11 may be approximately 90 µm. Each of the distances d₁ and d₂ may be smaller than or equal to half of the diameter D₁ of the micro holes 11. In one example, the first distance d₁ may be approximately 20 µm and the second distance d₂ may be approximately 20 µm. In other examples, the size of D₁ and the length of d₁ and d₂ may be longer or shorter to suit different applications.

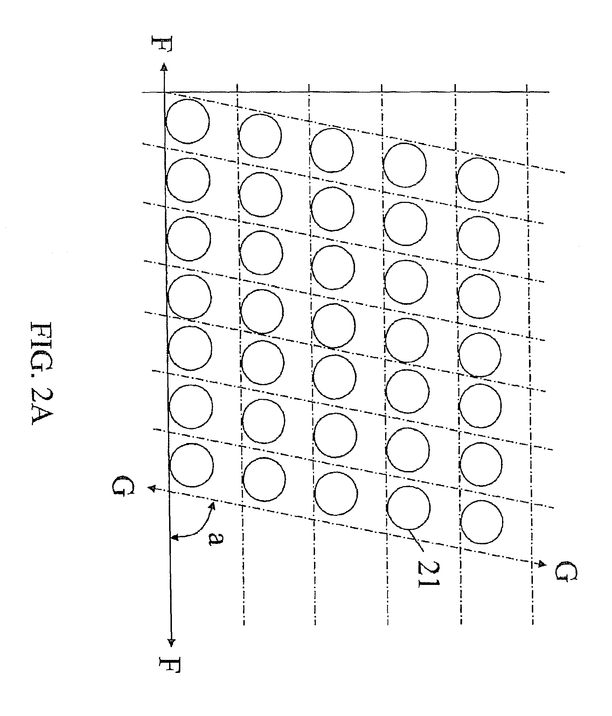

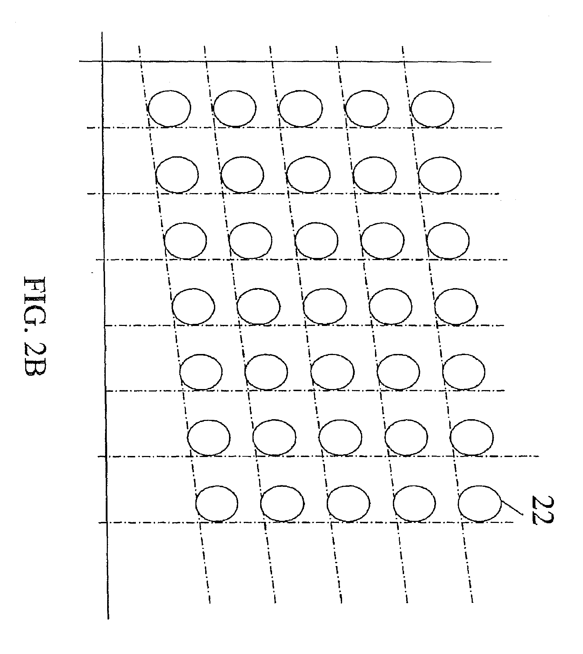

FIGS. 2A and 2B are schematic diagrams each illustrating an array of micro holes in accordance with another example of the present invention. Referring to FIG. 2A, an array of micro holes 21 may be arranged in a number of rows and columns. The number of rows may extend in a first direction "FF" and the number of columns may extend in a second direction "GG". The first direction FF and the second direction GG may intersect one another at an angle "a".

Referring to FIG. 2B, an array of micro holes 22 may be arranged in a similar pattern to the array of micro holes 21 illustrated in FIG. 2A. Each of the micro holes 22 may be similar to the micro holes 21 except that, for example, each of the micro holes 22 may have an elliptical shape while each of the micro holes 21 has a circular shape.

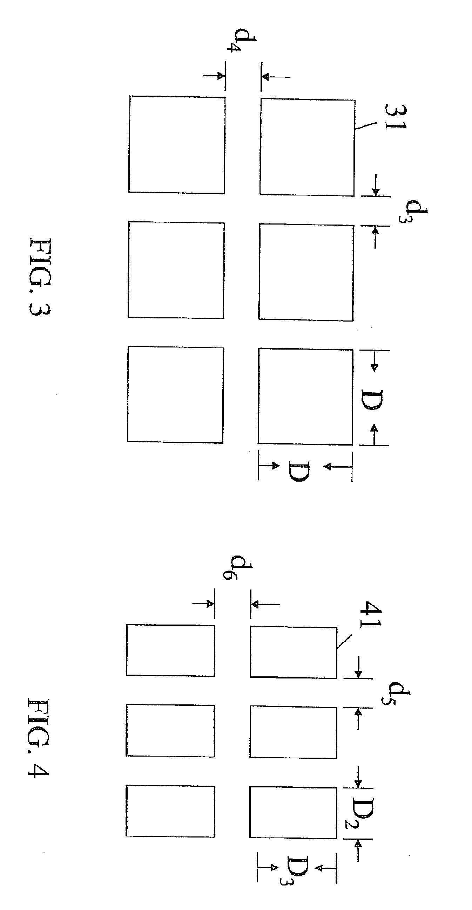

FIG. 3 is a schematic diagram illustrating an array of micro holes 31 in accordance with yet another example of the present invention. Referring to FIG. 3, the array of ultra-micro holes 31 may be arranged in a similar pattern to the array of micro holes 11 described and illustrated with reference to FIG. 1 except that, for example, each of the micro holes 31 may have a square shape while each of the micro holes 11 has a circular shape. The micro holes 31 in one of the rows may be separated from each other edge to edge by a first distance d₃, and the micro holes 31 in one of the columns may be separated from each other edge to edge by a second distance d₄. In one example, the length or width D of each of the micro holes 31 may be approximately 90 µm. Each of the distances d₃ and d₄ may be smaller than or equal to half of the length D of the micro holes 31. In one example, the first distance d₃ may be approximately 20 µm and the second distance d₄ may be approximately 20 µm.

FIG. 4 is a schematic diagram illustrating an array of micro holes 41 in accordance with still another example of the present invention. Referring to FIG. 4, the array of micro holes 41 may be arranged in a similar pattern to the array of micro holes 31 described and illustrated with reference to FIG. 3 except that, for example, each of the micro holes 41 may have a rectangular shape while each of the micro holes 31 has a square shape. The micro holes 41 in one of the rows may be separated from each other edge to edge by a first distance d₅, and the micro holes 41 in one of the columns may be separated from each other edge to edge by a second distance d₆. In one example, the length D₂ and the width D₃ of each of the micro holes 41 may be approximately 70 µm and 90 µm, respectively. Each of the distances d₅ and d₆ may be smaller than or equal to half of the length D₂ or the width D₃ of the micro holes 41. In one example, the first distance d₅ may be approximately 20 µm and the second distance d₆ may be approximately 20 µm.

In addition to the circular, elliptical, square and rectangular shapes described and illustrated in the above examples, skilled persons in the art will understand that a micro hole according to the present invention may include other geometrical shapes such as triangular and polynomial shapes.

The micro holes described and illustrated with reference to FIGS. 1, 2A, 2B, 3 and 4 may have different reflection ratios due to different sizes and edge-to-edge distances. A reflection ratio may refer to a ratio of the total coverage of micro holes to the area of a film or substrate on which the micro holes are formed. In the example shown in FIG. 1 with the parameters D₁, d₁ and d₂ being approximately 90, 20 and 20 µm, respectively, the reflection ratio may be approximately 72%. In the example shown in FIG. 3 with the parameters D, d₃ and d₄ being approximately 90, 20 and 20 µm, respectively, the reflection ratio may be approximately 76%. Furthermore, in the example shown in FIG. 4 with the parameters D₁, D₂, d₅ and d₆ being approximately 90, 70, 20 and 20 µm, respectively, the reflection ratio may be approximately 81 %.

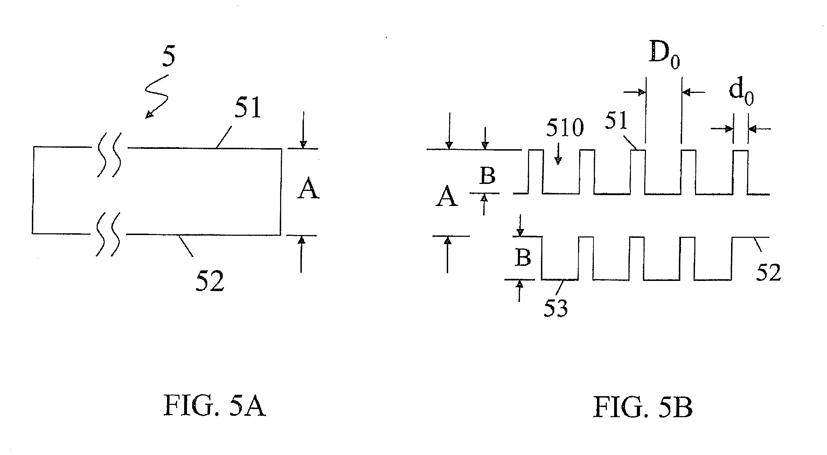

FIGS. 5A and 5B are schematic diagrams illustrating a process of forming micro holes in accordance with an example of the present invention. Referring to FIG. 5A, a roll of flexible film 5 may be provided. The film 5 may include but is not limited to a polymeric material selected from one of polychloroprene (PC), polystyrene (PS), polypropylene (PP), polychloroprene-polymethylmethacrylate (PC-PMMA) and polychloroprene-acrylonitrile butadiene styrene (PC-ABS). The film includes a first surface 51 and a second surface 52 separated from one another by a first thickness "A". In one example, the thickness A may be approximately 150 µm but may be thinner or thicker in other applications.

The roll of film 5 may be subject to a micro-punching process. Referring to FIG. 5B, a plurality of micro holes 510 with a depth "B" may be formed into the first surface 51 of the film 5 by using a micro-punching mold (not shown). The micro-punching mold may punch the first surface 51 to form the micro holes 510 row by row, column by column or one array after another, depending on the mold design. As a result, the micro holes 510 may be arranged in a similar pattern to one of the array of micro holes shown in FIGS. 1, 2A, 2B, 3 and 4. That is, each of the micro holes 510 may have a cross-sectional shape having at least one of a substantially circular, elliptical, square, rectangular, triangle, polynomial shape or other suitable geometric shapes. Accordingly, each of the micro holes 510 may have a diameter D₀ and may be separated from an adjacent micro hole 510 in a same row or same column by a distance d₀. In one examples, the depth "B" may be substantially half of the thickness "A". Furthermore, the distance d₀ may be equal to or smaller than half of the diameter D₀.

While punching the first surface 51 to form the micro holes 510, a plurality of protrusions 53 may be squeezed out of or extruded from the second surface 52 due to the elastic behavior of the film 5. Each of the protrusions 53, which is a portion of the film 5, may have substantially the same shape as a corresponding one of the micro holes 510. That is, each of the protrusions 53 may have a cross-sectional shape having at least one of a substantially circular, elliptical, square, rectangular, triangle, polynomial shape or other suitable geometric shapes. Furthermore, each of the protrusions 53 may have a thickness substantially the same as the depth "B" of a corresponding one of the micro holes 510.

The depth B of the micro holes 510 formed into the film 5 may determine the reflectivity of the film 5, which may in turn affect the luminance of a display using the film 5. In one example, the reflectivity of a film may increase as the depth of the micro holes formed into the film increases. Generally, small-size displays may require a relatively high reflection ratio while large-size displays may require a medial to small reflection ratio.

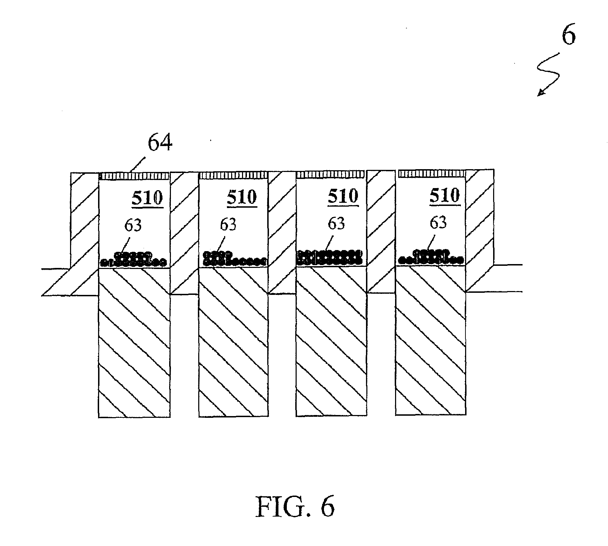

FIG. 6 is a schematic diagram illustrating a thin film display device 6 in accordance with an example of the present invention. Referring to FIG. 6, after the micro holes 510 are formed, an electroluminescent material 63 may be filled in the micro holes 510. The micro holes 510 may then be sealed by an appropriate adhesive such as gel. The electroluminescent material 63 may include one of liquid crystal (LC), organic semiconductors for organic light emitting diodes (OLED) and plasma ions.

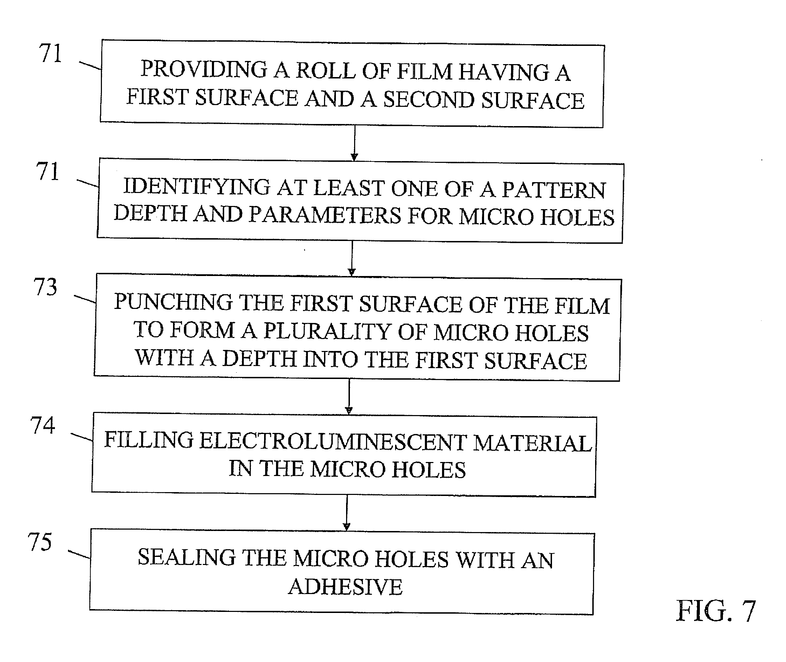

FIG. 7 is a flow chart illustrating a method of manufacturing a substrate with micro holes. Referring to FIG. 7, at step 71, a roll of flexible film having a first surface and a second surface is provided from, for example, a feeder machine. The roll of film may be subject to a micro-punching process to form an array of micro holes into the first surface for each predetermined section of the roll of film. Prior to the micro-punching, at step 72, at least a pattern of the array of micro holes, a depth of each of the micro holes or the parameters such as the diameter or edge-to-edge distance may be identified. Information regarding the pattern, depth and parameters may be processed by a micro processor unit, which may command a micro-punching mold to punch the first surface in accordance with the information. Next, at step 73, a plurality of micro holes may be formed into the first surface of each determined section of the roll of film. Each of the micro holes may have a depth identified at step 72. At step 74, an electroluminescent material may be filled in the micro holes. Subsequently, at step 75, an adhesive may be applied to a top of each of the micro holes to seal the electroluminescent material therein. In one example, after the micro holes are formed at step 73, the each predetermined section may be removed from the roll of film by, for example, a cutting process, and then the micro holes in the removed section may be filled with the electroluminescent material and then sealed therein. In another example, however, the each predetermined section may not be removed until the electroluminescent material is filled at step 74 and sealed at step 75.

In describing representative examples of the present invention, the specification may have presented the method and/or process of operating the present invention as a particular sequence of steps. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the specification should not be construed as limitations on the claims. In addition, the claims directed to the method and/or process of the present invention should not be limited to the performance of their steps in the order written, and one skilled in the art can readily appreciate that the sequences may be varied and still remain within the spirit and scope of the present invention.

It will be appreciated by those skilled in the art that changes could be made to the examples described above without departing from the broad inventive concept thereof. It is understood, therefore, that this invention is not limited to the particular examples disclosed, but it is intended to cover modifications within the spirit and scope of the present invention as defined by the appended claims.

## Claims

1. A method of fabricating a substrate with micro holes, the method comprising:
providing a roll of flexible film (5) having a first surface (51) and a second surface, the first surface and the second surface being separated from one another by a thickness (A) of the roll of flexible film;
identifying a depth (B) of the micro holes to be formed; and
punching the first surface of the roll of flexible film (5) to form a plurality of micro holes with a depth into the first surface.

2. The method of claim 1 further comprising identifying a pattern of the micro holes to be formed into the first surface.

3. The method of claim 1 or 2, further comprising punching the first surface of the roll of flexible film to form an array of micro holes in rows and columns, wherein the rows extend in a first direction and the columns extend in a second direction, the first direction and the second direction forming an angle with respect to one another.

4. The method of any of the preceding claims, further comprising identifying a set of parameters for the dimension of each of the micro holes to be formed into the first substrate.

5. The method of claim 4, wherein the set of parameters includes a diameter of each of the micro holes and an edge-to-edge distance between immediately adjacent micro holes, the edge-to-edge distance being smaller than or equal to half of the diameter.

6. The method of any of the preceding claims, wherein the depth (B) is half of the thickness (A).

7. The method of any of the preceding claims, further comprising filling an electroluminescent material (63) into the micro holes (510).

8. A method of fabricating a substrate with micro holes, the method comprising:
providing a roll of flexible film (5) having a first surface (51) and a second surface;
punching the first surface of at least a section of the roll of flexible film to form a plurality of micro holes with a depth (B) into the first surface of the section of the roll of flexible film;
filling electroluminescent material (63) into each of the micro holes (510); and
sealing a top portion of each of the micro holes.

9. The method of claim 8 further comprising:
removing one of the at least one section of the roll of flexible film after punching the first surface of the one section of the roll of flexible film; and
filling the electroluminescent material into the micro holes of the one section of the roll of flexible film.

10. The method of claim 8 further comprising:
removing one of the at least one section of the roll of flexible film after filling the electroluminescent material into the micro holes of the one section of the roll of flexible film.

11. The method of any of claims 8 to 10, further comprising identifying a set of parameters for the dimension of each of the micro holes (510) to be formed into the first substrate.

12. The method of claim 11, wherein the set of parameters includes a diameter of each of the micro holes and an edge-to-edge distance between immediately adjacent micro holes, the edge-to-edge distance being smaller than or equal to half of the diameter.

13. A substrate for a display device, the substrate comprising:
a flexible film (5) having a first surface (51) and a second surface;
a plurality of holes of a depth (B) formed into the first surface (51) of the flexible film, each of the holes having a diameter and being separated from an immediately adjacent hole by a distance; and
a plurality of protrusions protruded from the second surface of the flexible film, each of the protrusions corresponding to one of the holes.

14. The substrate of claim 13, wherein the flexible film includes a polymeric material selected from one of polychloroprene (PC), polystyrene (PS), polypropylene (PP), polychloroprene-polymethylmethacrylate (PC-PMMA) and polychloroprene-acrylonitrile butadiene styrene (PC-ABS).

15. The substrate of claim 13 or 14, wherein the plurality of holes are arranged in rows and columns, the rows extending in a first direction and the columns extending in a second direction, the first direction and the second direction forming an angle with respect to one another.

16. The substrate of any of claims 13 to 15, wherein each of the holes includes a cross-sectional shape having at least one of a circular, elliptical, square, rectangular, triangular and polynomial shape.

17. The substrate of any of claims 13 to 16, wherein the distance is smaller or equal to half of the diameter.

18. The substrate of any of claims 13 17, further comprising an electroluminescent material in each of the holes.

19. The substrate of claim 18 further comprising an adhesive layer at a top portion of each of the holes.

20. The substrate of any of claims 13 to 19, wherein each of the protrusions has a height equal to the depth.
